# FASCICULE DE BREVET EUROPEEN

(11) **EP 2 193 540 B1**
(45) Date de publication et mention de la délivrance du brevet: **26.07.2017**
(21) Numéro de dépôt: 08838888.9
(22) Date de dépôt: 26.09.2008
(51) Int. Cl.: H01L 21/268, H01L 21/428, H01L 21/324

(54) **PROCEDE DE CHAUFFAGE D'UNE PLAQUE PAR UN FLUX LUMINEUX**
VERFAHREN ZUR ERHITZUNG EINER PLATTE MIT EINEM LICHTSTROM
METHOD FOR HEATING A PLATE WITH A LIGHT STREAM

(30) Priorité: 01.10.2007 FR 0757986
(43) Date de publication de la demande: 09.06.2010
(73) Titulaire: Soitec, 38190 Bernin (FR)
(72) Inventeur: BRUEL, Michel, F-38113 Veurey Voroize (FR)
(74) Mandataire: Regimbeau
(86) Numéro de dépôt international: PCT/FR2008/051719
(87) Numéro de publication internationale: WO 2009/050381

(56) Documents cités:
- EP-A- 0 090 565
- EP-A- 1 083 590
- EP-A2- 0 032 211
- WO-A-01/80300
- WO-A-03/075329
- FR-A- 2 859 820
- JP-A- 61 056 409
- US-A- 6 110 813
- US-A1- 2006 043 367
- MACFARLANE, G. G: ET AL: "Fine Structure in the Absorption-Edge Spectrum of Si" PHYSICAL REVIEW, vol. 111, no. 5, 1 septembre 1958 (1958-09-01), pages 1245-1254, XP002471545
- GALECKAS A ET AL: "Temperature dependence of the absorption coefficient in 4H- and 6H-silicon carbide at 355 nm laser pumping wavelength" PHYSICA STATUS SOLIDI A, vol. 191, no. 2, juin 2002 (2002-06), pages 613-620, XP002471504

## Description

La présente invention se rapporte au domaine technique général du traitement de matériau, en particulier dans le domaine des couches minces, des plaquettes, des lames ou des lamelles de matériau, notamment de semi-conducteurs, en particulier de silicium.

Plus particulièrement, la présente invention se rapporte au domaine de l'application de traitements thermiques à des pièces au moyen de flux de lumière.

Dans l'état actuel de la technique, il existe des connaissances et procédés faisant appel à des flux de lumière pour réaliser des traitements thermiques, dans lesquels l'absorption des flux de lumière se produit à la surface extérieure et/ou au voisinage de la surface extérieure des pièces et le chauffage des parties plus profondes a lieu par diffusion thermique depuis la surface extérieure et/ou de son voisinage recevant le flux de lumière vers les zones plus profondes de la pièce à traiter.

La caractéristique de ces procédés de l'état de la technique est que les flux de lumière utilisés sont choisis de telle sorte que le matériau à traiter soit naturellement absorbant vis-à-vis du flux de lumière ou rendu absorbant par l'interaction directe du flux de lumière avec le matériau de la pièce, par exemple en utilisant des niveaux de puissance extrêmement élevés.

L'usage de flux de lumière s'avère particulièrement utile quand on veut pouvoir chauffer une couche superficielle pendant des temps très courts, de l'ordre de la fraction de microsecondes à quelques dizaines de microsecondes.

Néanmoins, l'épaisseur chauffée évoluant en général comme la racine carrée du temps depuis la surface extérieure de la pièce, il est extrêmement difficile et coûteux de chauffer des parties profondes de la pièce et ce de plus en plus difficile et coûteux au fur et à mesure qu'on s'intéresse à des profondeurs plus grandes.

De plus, le profil thermique obtenu dans la pièce présentant de façon générale un maximum à la surface extérieure et décroissant dans le matériau à partir de cette surface extérieure, il est nécessaire de limiter la température de surface à la température maximum que le matériau ne doit pas dépasser dans le cadre du procédé, par exemple la température de fusion ou de vaporisation ou de décomposition du matériau. Cette limite impose des flux modérés de puissance lumineuse et des grandes durées et donc des coûts élevés.

Par ailleurs, le document WO 03/075329 propose de chauffer une sous-couche absorbante par un flux lumineux au travers d'une couche antérieure, la chaleur produite dans la sous-couche chauffant par diffusion la couche antérieure, à une température inférieure à celle atteinte dans la sous-couche.

La présente invention a pour objet un procédé de chauffage, au moins local, d'une plaque comprenant au moins une couche à chauffer et une sous-couche, au moins locale, accolée à cette couche à chauffer, sous l'effet d'au moins une impulsion d'un flux lumineux.

Le procédé selon l'invention comprend les étapes suivantes :
choisir un flux lumineux
   - dont la longueur d'onde est telle que le coefficient d'absorption de ce flux par la couche à chauffer est faible tant que la température de cette couche à chauffer est dans une plage basse de température et que ce coefficient d'absorption augmente fortement quand la température de la couche à chauffer passe dans une plage haute de température située approximativement au-dessus de cette plage basse de température,
   - et dont l'intensité et la durée de l'impulsion sont telles qu'en l'absence de ladite sous-couche, la température de la couche à chauffer reste dans ladite plage basse de température ;
choisir une sous-couche
   - dont le coefficient d'absorption dudit flux lumineux à ladite longueur d'onde choisie est élevé dans ladite plage basse de température
   - et dont la température passe dans la plage haute de température lorsque cette sous-couche est soumise audit flux lumineux ;
et appliquer ledit flux lumineux à ladite plaque, au moins localement, par la face de ladite couche à chauffer opposée à ladite sous-couche.

Selon l'invention, il se produit le mécanisme suivant.

Dans une première phase, le flux lumineux chauffe la sous-couche depuis sa température initiale jusqu'à une température au moins située dans ladite plage haute de température.

Dans une seconde phase, la sous-couche chauffe par diffusion thermique la partie adjacente de la couche à chauffer jusqu'à une température située dans ladite plage haute de température.

Dans une troisième phase, cette partie adjacente étant ainsi devenue absorbante et générant, dans la couche à chauffer, un front thermique absorbant dont la température est située dans ladite plage haute de température, ce front thermique absorbant progresse vers ladite face avant sous l'effet conjugué ou double d'une diffusion thermique vers l'avant du front thermique et d'un apport d'énergie thermique par ledit flux lumineux qui atteint ce front thermique au travers du reste non encore absorbant de la couche à chauffer.

Selon l'invention, ladite plage basse de température et ladite plage haute de température peuvent être séparées par un seuil de transition de comportement du coefficient d'absorption en fonction de la température.

Selon l'invention, ledit seuil de transition de comportement du coefficient d'absorption en fonction de la température peut s'étendre sur une plage de température.

Selon l'invention, la couche à chauffer peut être du silicium peu dopé.

Selon l'invention, la couche à chauffer peut être un matériau semi-conducteur.

Selon l'invention, ladite plage basse de température peut correspondre sensiblement à la plage dans laquelle le dopage n'est pas intrinsèque et ladite plage haute de température peut correspondre sensiblement à la plage dans laquelle le dopage est intrinsèque.

Selon l'invention, la couche à chauffer peut être du nitrure de gallium.

Selon l'invention, la sous-couche peut être du silicium amorphe.

Selon l'invention, la sous-couche peut être du silicium fortement dopé.

Selon l'invention, la couche à chauffer peut être du nitrure de gallium et la sous-couche est du silicium.

Selon l'invention, le flux lumineux peut être généré par un laser.

La présente invention sera mieux comprise à l'étude de procédés de traitements thermiques décrits à titre d'exemples non limitatifs et illustrés par le dessin sur lequel :
- la figure 1 représente une coupe d'une plaque et un appareillage associé ;
- la figure 2 représente un mécanisme selon l'invention appliqué à la plaque de la figure 1, avec en abscisse la profondeur et en ordonnée la température ;
- la figure 3 représente une coupe d'une autre plaque ;
- les figures 4 et 5 représente un mécanisme selon l'invention appliqué à la plaque de la figure 3 ;
- les figures 6 et 7 représente un mode de fabrication d'une autre plaque représentée en coupe ;
- la figure 8 représente un mécanisme selon l'invention appliqué à la plaque de la figure 7 ;
- et la figure 9 représente un exemple d'utilisation du mécanisme selon l'invention, en référence à la figure 8.

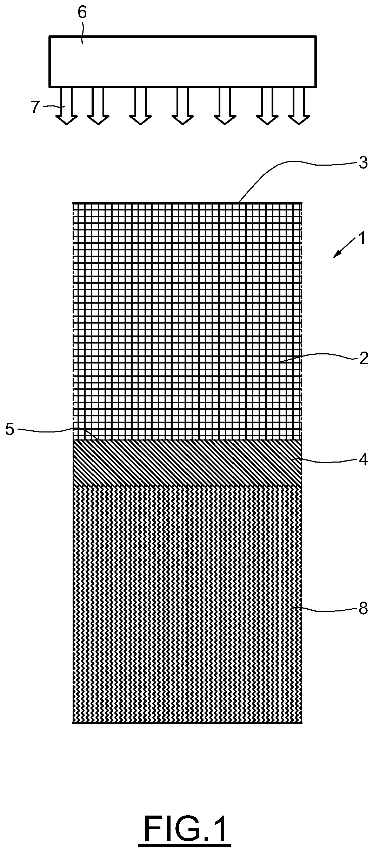

On a représenté sur la figure 1 une plaque 1 qui comprend une couche 2 qui présente une surface avant 3 et une sous-couche 4 accolée à la surface arrière 5 de la couche 2.

En face de la surface avant 5 de la couche 2 est installé un générateur 6 d'impulsions P d'un flux lumineux 7 vers cette surface avant 5.

Dans une variante, la plaque 1 peut comprendre une couche arrière 8 accolée à la face arrière de la sous-couche 4 pour former un support.

La couche 2 et le flux lumineux 7 sont choisis l'un par rapport à l'autre de façon à présenter les caractéristiques suivantes.

La longueur d'onde du flux lumineux 7 est telle que le coefficient d'absorption de ce flux par la couche 2 est faible tant que la température T de cette couche 2 est dans une plage basse de température PBT et que ce coefficient d'absorption augmente fortement quand la température T de la couche 2 passe dans une plage haute de température PHT située approximativement au-dessus de cette plage basse de température PBT.

L'intensité et la durée de l'impulsion délivrée par le flux lumineux 7 sont telles qu'en l'absence de la sous-couche 4, la température de la couche 2 reste dans ladite plage basse de température PBT.

La sous-couche 4 et le flux lumineux 7 sont choisis l'un par rapport à l'autre de façon à présenter les caractéristiques suivantes.

Le coefficient d'absorption par la sous-couche 4 du flux lumineux 7 à ladite longueur d'onde est élevé dans ladite plage basse de température PBT.

La température de la sous-couche 4, au moins dans son épaisseur adjacente à la couche 2, passe dans la plage haute de température PHT lorsque cette sous-couche 4 est soumise audit flux lumineux 7.

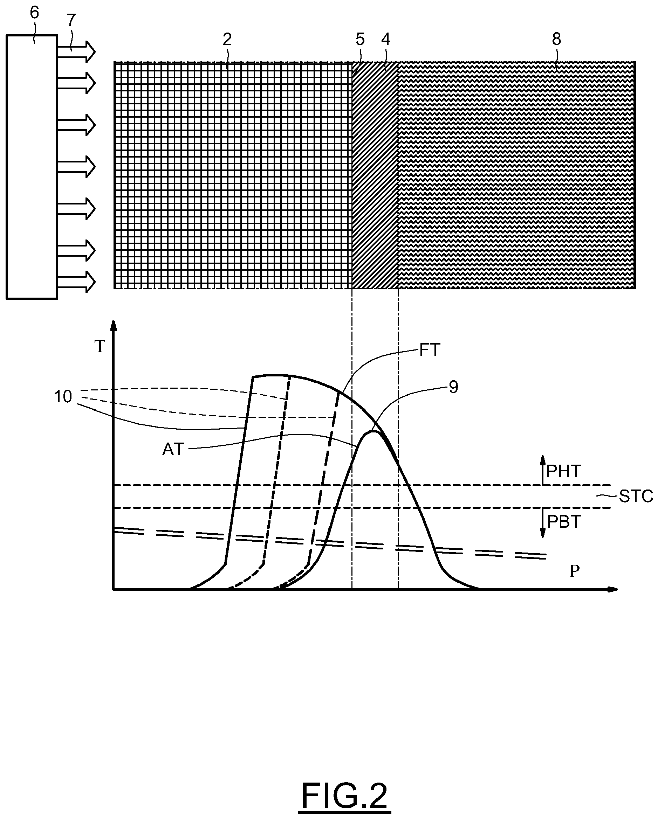

La plaque 1 étant à une température initiale située dans la plage basse de température PBT, on applique le flux lumineux 7 sur la plaque 1 par sa face avant 3. Il se produit alors les échauffements suivants tels que représentés sur la figure 2.

Dans l'exemple représenté, il est considéré que la limite supérieure LST de la plage basse de température PBT est inférieure à la limite inférieure LIT de la plage haute de température PHT. La plage basse de température PBT et la plage haute de température PHT sont séparées par un seuil STC de transition de comportement du coefficient d'absorption en fonction de la température qui s'étend sur une plage de température de transition.

Le mécanisme est le suivant.

Dans une première phase, le flux lumineux 7 traverse la couche 2 sans que sa température atteigne la plage haute de température PHT et, atteignant la sous-couche 4 en profondeur, chauffe cette sous-couche 4 depuis sa température initiale jusqu'à une température au moins située dans la plage haute de température PHT. On obtient la courbe de température 9.

Dans une seconde phase, la sous-couche 4 constitue une source thermique transitoire et chauffe par diffusion thermique la partie adjacente de la couche 2 jusqu'à une température AT située dans la plage haute de température PHT.

Dans une troisième phase, cette partie adjacente devient ainsi absorbante et génère, en profondeur dans la couche 2 à chauffer, un front thermique absorbant 10 dont la température FT est située dans la plage haute de température PHT, de préférence située au-dessus de la température AT. Ce front thermique absorbant 10, généré en profondeur, progresse vers la face avant 3 sous l'effet conjugué d'une diffusion thermique vers l'avant du front 10 et d'un apport d'énergie thermique par le flux lumineux 7 qui atteint ce front thermique 10 au travers du reste non encore absorbant de la couche 2.

Lorsque le flux 7 s'arrête, la progression du front thermique 10, selon ce mode de propagation, cesse quasi immédiatement dans la couche 2 s'il n'a pas atteint la face avant 3. L'évolution du front thermique 10 devient alors gouvernée uniquement par les effets de diffusion thermique.

Dans des conditions particulières de flux de lumière 7 constant, le chauffage de la couche 2 se produit sur une épaisseur sensiblement en relation linéaire avec la durée du flux thermique.

L'enchaînement ci-dessus des trois phases ci-dessus signifie qu'elles se produisent temporellement à la suite l'un de l'autre. Cependant, la description de cette succession n'exclut pas un recouvrement temporel partiel de ces phases.

### Exemples de mise en oeuvre.

Le flux lumineux 7 peut être une impulsion de laser CO2 de durée 6 microsecondes avec un flux de 3,75 *1.E6 W/Cm2

Le matériau transparent constituant la couche 2 peut être du silicium dopé à un niveau de l'ordre de 1.E15/Cm3 et placé initialement à la température ambiante.

Dans ces conditions, l'absorption du silicium est de l'ordre de quelques Cm-1, ce qui est faible et reste sensiblement constant tant que la température du silicium n'atteint pas environ 270°C. A partir environ de cette température, la concentration intrinsèque de porteurs devient supérieure à 1*E15 Cm-2 (Voir le document intitulé « Physics of Semiconductor Devices », second Edition, N°ISBN 0-07-062735-5, par S.M. SZE, John Wiley and Sons, page 20 - fig. 12 et page 26 - fig. 16).

La plage basse de température PBT est donc la plage de température sensiblement située au-dessous de la limite inférieure de température LIT égale à environ 270°C, tandis que la plage haute de température PHT est la plage sensiblement située au-dessus de 270°C. Conformément au document ci-dessus, la plage basse de température PBT est située dans le domaine non intrinsèque de saturation et/ou de gel des porteurs et la plage haute de température PHT est située dans le domaine intrinsèque.

Le matériau absorbant constituant la sous-couche 4 peut être du silicium dopé à un niveau de l'ordre de 1.E19/Cm3 et placé initialement à la température ambiante, ce qui lui confère un coefficient d'absorption de plusieurs centaines de Cm-1.

L'épaisseur de la couche 2 peut être d'environ 90 µm et l'épaisseur de la sous-couche 4 peut être d'environ 10 µm.

La réalisation de la sous-couche 4 peut être obtenue au moyen d'une épitaxie ou d'un dépôt ou d'une implantation ionique .

Selon un premier exemple d'obtention de la plaque 1, on réalise un substrat de silicium dopé à 1*E15Cm-3 et d'épaisseur égale à 100 µm par amincissement d'une plaquette de silicium standard. On réalise, à travers l'une des faces, une implantation d'ions bore à une dose de quelque 1*E16 /Cm2 et On réalise un recuit à une température de 1000°C à 1100°C environ pendant deux heures de façon à atteindre une profondeur de dopage de 10 microns environ pour obtenir la sous-couche 4, l'épaisseur restant de 90µm constituant la couche 2. La face non utilisée pour l'implantation constitue alors la face 3 au travers de laquelle le flux de lumière 7 sera appliqué.

Selon un second exemple d'obtention de la plaque 1, on réalise, sur un substrat de silicium standard, une épitaxie de silicium dopé en antimoine à 1*E19/Cm3 et de 10 microns d'épaisseur pour constituer la sous-couche 4. Ensuite, au-dessus de l'épitaxie de 10 microns, on réalise une épitaxie de silicium dopé à 1*E15/Cm3 et de 90 microns d'épaisseur pour constituer la couche 2.

A titre d'exemples complémentaires, le matériau absorbant de la sous-couche 4 aurait pu être aussi, dans le cas où on utilise un laser CO2, une couche amorphe de silicium, une couche totalement ou partiellement amorphisée par implantation ionique , ou une couche d'oxyde de silicium SiO2.

Si l'on imagine une pièce constituée exclusivement de la couche 2, sans la sous-couche 4, et que l'on applique le flux de lumière défini plus haut, on peut constater que la température du matériau augmente de moins de 30°C. Ce résultat résulte d'une simulation par résolution de l'équation de la chaleur par une méthode dite des différences finies, méthode qui fait partie de l'état de l'art.

Ce résultat aurait pu être obtenu aussi en appliquant le formalisme simple suivant :
- identification de la valeur maximum Alphamax du coefficient d'absorption sur la plage basse de température PBT
- l'ordre de grandeur de la température maximum atteinte Tmax est alors donnée par Tmax=Phi*tau*alphamax/Cp

Où Cp est la capacité calorifique, Phi est le flux, Tau est la durée du flux, Cp la chaleur volumique,

Et avec Phi est égal à 3,75*1.E6W/Cm2, tau --- égal à 6*1.E-6 S - alphamax --- égal à 2Cm-1 - Cp --- égal à 1,4 J/Cm3.

On trouve alors que l'ordre de grandeur de la température maximum Tmax atteinte de la couche 2 unique est égal à 32 °C.

On constate bien que dans ces conditions la température de la couche 2 reste très faible et à l'intérieur de la plage basse de température PBT.

Par contre, en présence de la sous-couche 4, il est possible de chauffer une grande épaisseur de matériau transparent jusqu'à des températures de l'ordre de 1650K sur des épaisseurs de l'ordre de 60µm. Ce résultat résulte d'une simulation par résolution de l'équation de la chaleur par une méthode dite des différences finies, méthode qui fait partie de l'état de l'art.

### Exemples d'application.

### Exemple 1.

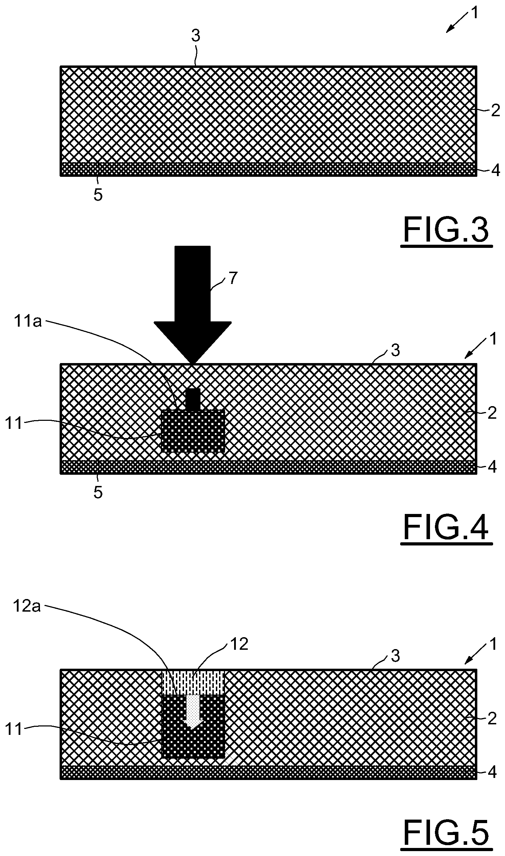

Comme le montre la figure 3, partant d'un substrat de silicium polycristallin, non dopé et à grains désorientés, on oxyde l'une de ses faces par les techniques classiques utilisées en microélectronique et on obtient une plaque 1 qui comprend une couche 2 de silicium monocristallin, non dopé et à grains désorientés et une sous-couche 4 d'oxyde de silicium.

Ainsi, à la température ambiante, cette couche 2 est sensiblement transparente au flux lumineux généré par un laser CO2 et la sous-couche 4 est absorbante d'un tel flux lumineux.

Ensuite, comme le montre la figure 4, on applique une irradiation d'un tel flux lumineux, sous forme impulsionnelle, par la face avant 3 de la couche 2, par exemple localement sur une ou plusieurs zones.

Cette application produit, sous l'effet du chauffage préalable de la sous-couche 4 et selon le mécanisme comme décrit précédemment, une liquéfaction par chauffage de la couche 2 sur une zone 11 correspondant approximativement à la zone d'application du flux lumineux, cette zone liquéfiée 11 démarrant sur la face arrière 5 de la couche 2 ou à proximité immédiate de cette face arrière 5 et dont le front thermique 11a progresse vers l'avant jusqu'à par exemple atteindre la face avant 3.

Comme le montre la figure 5, après la fin de l'application du flux lumineux, il se produit un front de refroidissement 12a de la zone 11 depuis la face avant 3. Ce front 12a progresse vers l'arrière jusqu'à la face arrière 5 pour former une zone 12 dans laquelle le silicium se re-solidifie en se recristallisant en silicium polycristallin. Du fait des gradients de température, la recristallisation génère des grains éventuellement plus gros et orientés sensiblement perpendiculairement à l'épaisseur de la couche 2.

Par balayage, on pourrait traiter toute la couche 2.

Une telle zone peut présenter de meilleures propriétés électriques et peut être avantageuse pour la création de cellules photovoltaïques

### Exemple 2.

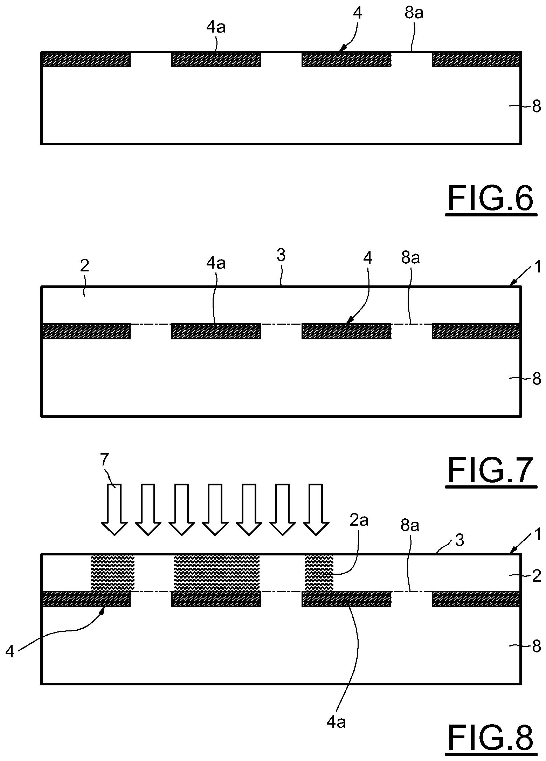

Comme le montre la figure 6, partant d'un substrat de silicium monocristallin non dopé, constituant un support arrière 8, on crée des zones locales 4a par dopage superficiel d'une face 8a de ce substrat d'environ 1E20/Cm-3 de type n par les techniques classiques utilisées en microélectronique, de façon à obtenir une sous-couche absorbante 4 constituée de ces zones locales 4a. Par exemple, chaque zone 4a est carrée et présente une épaisseur d'environ 2 microns et des côtés égaux à environ 50 microns, l'espacement entre les zones 4a étant d'environ 25 microns.

Ensuite, comme le montre la figure 7, on réalise une épitaxie de silicium non dopé sur la face 8a de façon à former une couche 2.

Ensuite, comme le montre la figure 8, on applique sur la face avant 3 un faisceau ou flux lumineux 7 de puissance infrarouge (par exemple un laser de puissance à fibre dopée ytterbium), déposant 20 joules/cm2 de surface en quelques centaines de nanosecondes. On provoque alors, comme décrit précédemment, un chauffage au moins local des zones 2a de la couche 2 situées entre les zones 4a de la sous-couche 4 et la face avant 3, sans chauffer les autres parties de la couche 2. On peut alors utiliser ce chauffage différentiel pour réaliser un traitement des zones 2a chauffées.

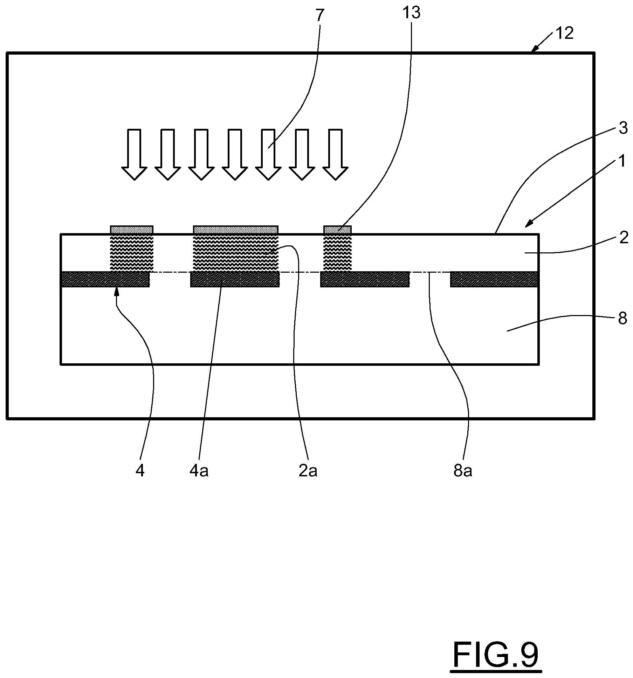

Par exemple, comme le montre la figure 9, on peut réaliser le chauffage obtenu ci-dessus en référence à la figure 8 dans une enceinte 12 contenant de l'oxygène et/ou de la vapeur d'eau. La présence d'oxygène et l'élévation de la température localisée dans les zones 2a de la couche 2 conduit à la création de zones 13 d'oxyde de silicium sur la face avant 3 de la couche 2, auto-alignées au-dessus des zones profondes 4a.

## Revendications

1. Procédé de chauffage, au moins local, d'une plaque (1) comprenant au moins une couche à chauffer (2) et une sous-couche (4), au moins locale, accolée à cette couche à chauffer, sous l'effet d'au moins une impulsion d'un flux lumineux, comprenant les étapes suivantes :
Choisir un flux lumineux (7)
- dont la longueur d'onde est telle que le coefficient d'absorption de ce flux par la couche à chauffer (2) est faible par rapport au coefficient d'absorption de ce flux par la sous-couche (4) tant que la température de cette couche à chauffer est dans une plage basse de température (PBT) et que ce coefficient d'absorption augmente fortement quand la température de la couche à chauffer passe dans une plage haute de température (PHT) située au-dessus de cette plage basse de température,
- et dont l'intensité et la durée de l'impulsion sont telles qu'en l'absence de ladite sous-couche, la température de la couche à chauffer reste dans ladite plage basse de température ;
Choisir une sous-couche (4)
- dont le coefficient d'absorption dudit flux lumineux à ladite longueur d'onde choisie est élevé par rapport au coefficient d'absorption de ce flux par la couche à chauffer (2) dans ladite plage basse de température (PBT)
- et dont la température passe dans la plage haute de température (PHT) lorsque cette sous-couche est soumise audit flux lumineux ;
Et appliquer ledit flux lumineux (7) à ladite plaque (1), au moins localement, par la face (3) de ladite couche à chauffer (2) opposée à ladite sous-couche (4) ;
De telle sorte que, dans une première phase, le flux lumineux (7) chauffe la sous-couche (4) depuis sa température initiale jusqu'à une température au moins située dans ladite plage haute de température (PHT), que, dans une seconde phase, la sous-couche (4) chauffe par diffusion thermique la partie adjacente de la couche à chauffer (2) jusqu'à une température (AT) située dans ladite plage haute de température (PHT), et que, dans une troisième phase, cette partie adjacente étant ainsi devenue absorbante et générant, dans la couche à chauffer (2), un front thermique absorbant (10) dont la température est située dans ladite plage haute de température (PHT) et est supérieure à la température (AT) de la sous-couche (4), ce front thermique absorbant (10) progresse vers ladite face avant (3) sous l'effet conjugué d'une diffusion thermique vers l'avant du front thermique (10) et d'un apport d'énergie thermique par ledit flux lumineux (7) qui atteint ce front thermique au travers du reste non encore absorbant de la couche à chauffer (2).

2. Procédé selon la revendication 1, **caractérisé par le fait que** ladite plage basse de température (PBT) et ladite plage haute de température (PHT) sont séparées par un seuil de transition de comportement du coefficient d'absorption en fonction de la température.

3. Procédé selon la revendication 2, **caractérisé par le fait que** ledit seuil (STC) de transition de comportement du coefficient d'absorption en fonction de la température s'étend sur une plage de température.

4. Procédé selon l'une quelconque des revendications précédentes, **caractérisé par le fait que** la couche à chauffer (2) est du silicium peu dopé.

5. Procédé selon l'une quelconque des revendications précédentes, **caractérisé par le fait que** la couche à chauffer (2) est un matériau semi-conducteur.

6. Procédé selon la revendication 5 **caractérisé en ce que** ladite plage basse de température (PBT) correspond sensiblement à la plage dans laquelle le dopage n'est pas intrinsèque et que ladite plage haute de température (PHT) correspond sensiblement à la plage dans laquelle le dopage est intrinsèque.

7. Procédé selon l'une quelconque des revendications 1 à 3, **caractérisé par le fait que** la couche à chauffer (2) est du nitrure de gallium.

8. Procédé selon l'une quelconque des revendications précédentes, **caractérisé par le fait que** la sous-couche (4) est du silicium amorphe.

9. Procédé selon l'une quelconque des revendications précédentes, **caractérisé par le fait que** la sous-couche (4) est du silicium fortement dopé.

10. Procédé selon l'une quelconque des revendications précédentes, **caractérisé par le fait que** la couche à chauffer (2) est du nitrure de gallium et la sous-couche est du silicium.

11. Procédé selon l'une quelconque des revendications précédentes, **caractérisé par le fait que** le flux lumineux (7) est généré par un laser.

## Patentansprüche

1. Verfahren zum zumindest stellenweisen Erhitzen einer Platte (1), die zumindest eine zu erhitzende Schicht (2) und eine zumindest stellenweise Unterschicht (4) umfasst, die an diese zu erhitzende Schicht angefügt ist, unter der Wirkung von zumindest einem Impuls eines Lichtstroms, umfassend die folgenden Schritte:
Auswählen eines Lichtstroms (7),
- dessen Wellenlänge derart ist, dass der Koeffizient der Absorption dieses Stroms durch die zu erhitzende Schicht (2) im Verhältnis zum Koeffizienten der Absorption dieses Stroms durch die Unterschicht (4) niedrig ist, solange die Temperatur dieser zu erhitzenden Schicht in einem Niedertemperaturbereich (NTB) ist, und dass dieser Absorptionskoeffizient stark ansteigt, wenn die Temperatur der zu erhitzenden Schicht in einen Hochtemperaturbereich (HTB) übergeht, der über diesem Niedertemperaturbereich liegt,
- und von dem die Intensität und die Dauer des Impulses derart sind, dass beim Fehlen der Unterschicht die Temperatur der zu erhitzenden Schicht in dem Niedertemperaturbereich bleibt;
Auswählen einer Unterschicht (4),
- deren Koeffizient der Absorption des Lichtstroms bei der gewählten Wellenlänge im Verhältnis zum Koeffizienten der Absorption dieses Stroms durch die zu erhitzende Schicht (2) in dem Niedertemperaturbereich (NTB) hoch ist
- und deren Temperatur in den Hochtemperaturbereich (HTB) übergeht, wenn diese Unterschicht dem Lichtstrom ausgesetzt wird;
und zumindest stellenweises Anlegen des Lichtstroms (7) auf die Platte (1) über die Fläche (3) der zu erhitzenden Schicht (2), die der Unterschicht (4) gegenüberliegt;
derart, dass in einer ersten Phase der Lichtstrom (7) die Unterschicht (4) von ihrer Anfangstemperatur zumindest bis auf eine Temperatur erhitzt, die in dem Hochtemperaturbereich (HTB) liegt, dass in einer zweiten Phase die Unterschicht (4) den angrenzenden Teil der zu erhitzenden Schicht (2) durch thermische Diffusion bis auf eine Temperatur (AT) erhitzt, die in dem Hochtemperaturbereich (HTB) liegt, und dass in einer dritten Phase dieser angrenzende Teil somit absorbierend geworden ist und in der zu erhitzenden Schicht (2) eine absorbierende thermische Front (10) erzeugt, deren Temperatur in dem Hochtemperaturbereich (HTB) liegt und höher als die Temperatur (AT) der Unterschicht (4) ist, wobei sich diese absorbierende thermische Front (10) unter der kombinierten Wirkung einer thermischen Diffusion in Richtung der Vorderseite der thermischen Front (10) und einer Zufuhr von thermischer Energie durch den Lichtstrom (7), die diese thermische Front durch den noch nicht absorbierenden Rest der zu erhitzenden Schicht (2) hindurch erreicht, in Richtung der vorderen Fläche (3) bewegt.

2. Verfahren nach Anspruch 1, **dadurch gekennzeichnet, dass** der Niedertemperaturbereich (NTB) und der Hochtemperaturbereich (HTB) durch eine temperaturabhängige Verhaltensübergangsschwelle des Absorptionskoeffizienten getrennt sind.

3. Verfahren nach Anspruch 2, **dadurch gekennzeichnet, dass** die temperaturabhängige Verhaltensübergangsschwelle (VÜS) des Absorptionskoeffizienten sich über einen Temperaturbereich erstreckt.

4. Verfahren nach einem der vorstehenden Ansprüche, **dadurch gekennzeichnet, dass** die zu erhitzende Schicht (2) wenig dotiertes Silizium ist.

5. Verfahren nach einem der vorstehenden Ansprüche, **dadurch gekennzeichnet, dass** die zu erhitzende Schicht (2) ein Halbleitermaterial ist.

6. Verfahren nach Anspruch 5, **dadurch gekennzeichnet, dass** der Niedertemperaturbereich (NTB) im Wesentlichen dem Bereich entspricht, in dem die Dotierung nicht intrinsisch ist, und dass der Hochtemperaturbereich (HTB) im Wesentlichen dem Bereich entspricht, in dem die Dotierung intrinsisch ist.

7. Verfahren nach einem der Ansprüche 1 bis 3, **dadurch gekennzeichnet, dass** die zu erhitzende Schicht (2) Galliumnitrid ist.

8. Verfahren nach einem der vorstehenden Ansprüche, **dadurch gekennzeichnet, dass** die Unterschicht (4) amorphes Silizium ist.

9. Verfahren nach einem der vorstehenden Ansprüche, **dadurch gekennzeichnet, dass** die Unterschicht (4) stark dotiertes Silizium ist.

10. Verfahren nach einem der vorstehenden Ansprüche, **dadurch gekennzeichnet, dass** die zu erhitzende Schicht (2) Galliumnitrid ist und die Unterschicht Silizium ist.

11. Verfahren nach einem der vorstehenden Ansprüche, **dadurch gekennzeichnet, dass** der Lichtstrom (7) durch einen Laser erzeugt wird.

## Claims

1. Method for heating, at least local, a wafer (1) comprising at least one layer to be heated (2) and a sub-layer (4), at least local, adjacent to said layer to be heated, under the effect of at least one light flux pulse, comprising the following steps:
Selecting a light flux (7)
- wherein the wavelength is such that the absorption coefficient of said flux by the layer to be heated (2) is low in relation to the absorption coefficient of said flux by the sub-layer (4) as long as the temperature of said layer to be heated is in a low temperature range (PBT) and said absorption coefficient increases significantly when the temperature of the layer to be heated enters a high temperature range (PHT) situated above said low temperature range,
- and wherein the pulse intensity and duration are such that, in the absence of said sub-layer, the temperature of the layer to be heated remains within said low temperature range;
Selecting a sub-layer (4)
- wherein the absorption coefficient of said light flux at said selected wavelength is high in relation to the absorption coefficient of said flow by the layer to be heated (2) in said low temperature range (PBT);
- and wherein the temperature enters the high temperature range (PHT) when said sub-layer is subject to said light flux;
And applying said light flux (7) to said wafer (1), at least locally, via the face (3) of said layer to be heated (2) opposite said sub-layer (4);
Such that, in a first phase, the light flux (7) heats the sub-layer (4) from the initial temperature thereof to a temperature at least situated in said high temperature range (PHT), that, in a second phase, the sub-layer (4) heats, by thermal diffusion, the adjacent portion of the layer to be heated (2) to a temperature (AT) situated in said high temperature range (PHT), and that, in a third phase, this adjacent portion thus becoming absorbent and generating, in the layer to be heated (2), an absorbent thermal front (10) wherein the temperature is situated in said high temperature range (PHT) and is greater than the temperature (AT) of the sub-layer (4), said absorbent thermal front (10) progresses towards said front face (3) under the combined effect of forward thermal diffusion of the thermal front (10) and a thermal energy supply by said light flux (7) which reaches said thermal front via the not yet absorbent remainder of the layer to be heated (2).

2. Method according to claim 1, **characterised in that** said low temperature range (PBT) and said high temperature range (PHT) are separated by a behaviour transition threshold of the absorption coefficient as a function of the temperature.

3. Method according to claim 2, **characterised in that** said behaviour transition threshold (STC) of the absorption coefficient as a function of the temperature extends over a temperature range.

4. Method according to any of the above claims, **characterised in that** the layer to be heated (2) is low-doped silicon.

5. Method according to any of the above claims, **characterised in that** the layer to be heated (2) is a semiconductor material.

6. Method according to claim 5 **characterised in that** said low temperature range (PBT) corresponds substantially to the range wherein the doping is not intrinsic and said high temperature range (PHT) corresponds substantially to the range wherein the doping is intrinsic.

7. Method according to any of claims 1 to 3, **characterised in that** the layer to be heated (2) is gallium nitride.

8. Method according to any of the above claims, **characterised in that** the sub-layer (4) is amorphous silicon.

9. Method according to any of the above claims, **characterised in that** the sub-layer (4) is high-doped silicon.

10. Method according to any of the above claims, **characterised in that** the layer to be heated (2) is gallium nitride and the sub-layer is silicon.

11. Method according to any of the above claims, **characterised in that** the light flux (7) is generated by a laser.
